(19) Europäisches Patentamt
European Patent Office
Office européen des brevets

(11) **EP 4 084 255 A1**

(12) **EUROPEAN PATENT APPLICATION**
published in accordance with Art. 153(4) EPC

(43) Date of publication:
**02.11.2022 Bulletin 2022/44**

(21) Application number: **20901962.9**

(22) Date of filing: **16.12.2020**

(51) International Patent Classification (IPC):
***H02J 3/18*** (2006.01)   ***H02N 2/18*** (2006.01)
***H01L 41/113*** (2006.01)   ***H01L 27/20*** (2006.01)

(52) Cooperative Patent Classification (CPC):
Y02E 40/30

(86) International application number:
**PCT/KR2020/018402**

(87) International publication number:
**WO 2021/125769 (24.06.2021 Gazette 2021/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.12.2019 KR 20190168735**

(71) Applicant: **Baik, Seung Hyun**
**Sujeong-gu**
**Seongnam-si, Gyeonggi-do 13449 (KR)**

(72) Inventors:
• **BAIK, Yun Jong**
**Namyangju-si, Gyeonggi-do 12026 (KR)**
• **KIM, Hyeon Ho**
**Yeosu-si, Jeollanam-do 59641 (KR)**
• **BAIK, Seung Hyun**
**Seongnam-si, Gyeonggi-do 13449 (KR)**

(74) Representative: **Morabito, Sara et al**
**Cantaluppi & Partners S.r.l.**
**Piazzetta Cappellato Pedrocchi, 18**
**35122 Padova (IT)**

(54) **POWER FACTOR IMPROVEMENT AND POWER GENERATION APPARATUS USING PIEZOELECTRIC ELEMENT**

(57)    A power factor improvement and power generation apparatus using a piezoelectric element may include: a first piezoelectric element having first and second electrodes, and vibrating when voltage is applied from a power line; and a second piezoelectric element having first and second electrodes, and generating electricity in accordance with vibration of the first piezoelectric element. This apparatus is possible to improve a power factor of a power line and generate power using the inherent condenser component, which a piezoelectric element has, instead of a power factor compensation condenser, and it is also possible to generate power.

[FIG. 1]

**Description**

Field of the invention

The present invention relates to a power factor improvement and power generation apparatus using a piezoelectric element, particularly, to a power factor improvement and power generation apparatus using a piezoelectric element, the apparatus being able to improve a power factor of a power line and generate power using the inherent condenser component, which a piezoelectric element has, instead of a power factor compensation condenser.

Background of the invention

In general, a power factor is the ratio of active power to apparent power. That is, a power factor is the ratio of the power that actually works to the entire power. Such a power factor is used as a main control factor where a technology of controlling power or preventing waste of power consumption is required.

Power factor control is to increase the power factor of a load up to a target power factor, and a power factor control method that is generally used for power facilities increases a power factor by decreasing the apparent power. Apparent power is in connection with reactive power, the larger the reactive power, the larger the apparent power, and the smaller the reactive power, the smaller the apparent power. Accordingly, a power factor is compensated for by decreasing apparent power by reducing reactive power.

It is possible to achieve the following effects by improving only a power factor without changing other conditions when transmitting the same power.

① reduction of loss of transformer and power transmission line
② increase of reserve of generating capacity
③ reduction of voltage drop

Further, the power factor of a distribution line is improved by connecting a power condenser to a load in parallel, and the following three cases are installation methods that are generally employed.

① installing a condenser bank intensively at a transformer station or at the pole of a distribution line
② installing a condenser bank at an incoming panel of a user
③ installing a condenser bank directly at a load

In the above three installation methods, generally, ① is made by a power supplier, and ② and ③ are made by a user. Since the condenser bank is installed close to a load, there is an advantage that a power factor improvement effect is direct and influences the entire system, but the capacity utilization rate is low, so ① is also necessary.

Further, there is a lot of effort to improve a power factor as specified in Article 41 (maintenance of power factor) and Article 43 (addition or reduction of fee depending on power factor) of the basic terms and conditions of supply(July 01, 2019) by KEPCO(Korea Electric Power Corporation).

A distribution line has a problem of a low power factor when the load is an inductive load. Accordingly, a power condenser for improving the power factor of a distribution line is connected with a load in parallel.

A power condenser bank is used in parallel connection to a load to improve the power factor of a distribution line, but the condenser bank cannot be used for other purposes except for the purpose of improving a power factor and there is no other additional effect.

Accordingly, there is a need for an apparatus that can improve a power factor, can generate power, and can adjust the temperature of the space in an enclosure usefully using reactive power even without using a power condenser for a distribution line or a power line.

**SUMMARY** OF THE INVENTION

An objective of the present invention proposed to solve the problems described above is to provide a power factor improvement and power generation apparatus using a piezoelectric element, the apparatus being able to improve a power factor of a power line and generate power using the inherent condenser component, which a piezoelectric element has, instead of a power factor compensation condenser.

Another objective of the present invention is to provide a power factor improvement and power generation apparatus using a piezoelectric element, the apparatus being able to usefully use reactive power without using specific power by enabling mechanical displacement, which is caused by bending of a membrane member disposed between a first piezoelectric element and a second electric element and fixed to a supporting member, to be used as a cooling fan that removes heat in an enclosure.

The technical subject to implement in the present invention is not limited to the technical problems described above and other technical subjects that are not stated herein will be clearly understood by those skilled in the art from the following specifications.

In order the achieve the objectives, a power factor improvement and power generation apparatus using a piezoelectric element according to an embodiment of the present invention may include: a first piezoelectric element having first and second electrodes, and vibrating when voltage is applied from a power line; and a second piezoelectric element having first and second electrodes, and generating electricity in accordance with vibration of the first piezoelectric element.

The power factor improvement and power generation apparatus using a piezoelectric element according to an embodiment of the present invention may further include an insulator disposed between the first piezoelectric element and the second piezoelectric element.

The first piezoelectric element may have a structure that generates transverse vibration, longitudinal vibration, or shearing vibration, and the second piezoelectric element may have a structure that generates transverse vibration, longitudinal vibration, or shearing vibration in accordance with vibration of the first piezoelectric element.

The power factor improvement and power generation apparatus using a piezoelectric element according to an embodiment of the present invention may further include: a membrane member positioned between the first piezoelectric element and the second piezoelectric element; and a supporting member supporting the membrane member, in which the membrane member may generate mechanical displacement through a bending motion generated in a fixed state to the supporting member, and the second piezoelectric element may vibrate and generate electricity by the bending motion.

Pluralities of the first and second piezoelectric elements may be provided, the first piezoelectric element and the second piezoelectric element may be disposed on the top, the bottom, or a combination thereof of the membrane member, and at least one second piezoelectric element may be disposed on each of the top and the bottom of the membrane member.

The first piezoelectric element may be used as a material of a condenser for compensating a power factor of the power line, the plurality of the first piezoelectric element may be provided and they may be connected to the power line in parallel, and the apparatus may further include an automatic power factor control unit selectively controlling the first piezoelectric elements connected in parallel by the amount required by a load.

The automatic power factor control unit may include: an automatic power factor controller that automatically controls a power factor on the basis of current and voltage measured by an ammeter and a voltmeter; and a switching unit that is electrically connected to the automatic power factor controller to switch connection with the first piezoelectric elements in accordance with control of the automatic power factor controller.

The power factor improvement and power generation apparatus using a piezoelectric element according to an embodiment of the present invention may further include a weight attached to an end of the membrane member.

The present invention has an effect that it is possible to improve a power factor of a power line using an inherent condenser component, which a piezoelectric element has, instead of a power factor compensation condenser, and it is also possible to generate power.

Further, the present invention can usefully use reactive power without using specific power by enabling mechanical displacement, which is caused by bending of a membrane member disposed between a first piezoelectric element and a second electric element and fixed to a supporting member, to be used as a cooling fan that removes heat in an enclosure.

In particular, since external cold air flows inside and internal hot air flows outside even without using a separate cooling fan on the wall of an enclosure partition, the surrounding temperature in the enclosure can be adjusted to the regulated temperature by International Standards IEX 60831-2 and Korea Standards KSC 4801 which is the same as International Standards.

Further, according to the present invention, since at least one second piezoelectric element is disposed on each of the top and the bottom of a membrane member fixed to a supporting member and generating a bending motion, it is possible to always generate electricity during the bending motion. Accordingly, there is an effect that it is possible to smoothly supply power to equipment, areas, etc. that require electricity.

According to the present invention, since a plurality of first piezoelectric elements are connected in parallel to a power line, it is possible to increase the power factor of power by selectively controlling the first piezoelectric elements by the capacity of a condenser that requires power factor improvement.

The effects of the present invention are not limited to the effects described above and other effects can be clearly understood by those skilled in the art from the following description.

**BRIEF DESCRIPTION OF THE DRAWINGS**

FIG. 1 is a view illustrating a power factor improvement and power generation apparatus using a piezoelectric element according to an embodiment of the present invention.

FIGS. 2 to 7 are views illustrating a power factor improvement and power generation apparatus using a piezoelectric element according to another embodiment of the present invention.

FIG. 8 is a view illustrating a power factor improvement and power generation apparatus using a piezoelectric element according to another embodiment of the present invention.

FIG. 9 is a view illustrating an automatic power factor improvement apparatus shown in FIG. 8.

FIG. 10A is a perspective view illustrating an actuator equipped with first and second piezoelectric elements on the top and bottom of a membrane member.

FIG. 10B is a cross-sectional view of the actuator shown in FIG. 10A.

FIG. 11 is a view illustrating a power factor improvement and power generation apparatus using a piezoelectric element according to another embodiment of the present invention.

FIG. 12 is a cross-sectional view of a bimorph type actuator element.

FIG. 13 is a view showing a bending motion of a cantilever type for illustrating the principle of the present invention.

FIGS. 14A and 14B are cross-sectional views of an actuator additionally installed at an end of a membrane member.

## DETAILED DESCRIPTION OF THE INVENTION

Hereinafter, some embodiments of the present invention are described in detail with exemplary drawings. It should be noted that when components are given reference numerals in the drawings, the same components are given the same reference numerals even if they are shown in different drawings. In describing the present invention, well-known functions or constructions will not be described in detail since they may unnecessarily obscure the understanding of the present invention.

Terms 'first', 'second', 'A', 'B', '(a)', and '(b)' can be used in the following description of the components of embodiments of the present invention. These terms are provided only for discriminating components from other components and, the essence, sequence, or order of the components are not limited by the terms. Throughout the present specification, unless explicitly described otherwise, "comprising" and "having" any components will be understood to imply the inclusion of other components rather than the exclusion of any other components. Further, the terms '~ part', '~ unit', etc. described herein mean a unit circuit that processes at least one function or operation.

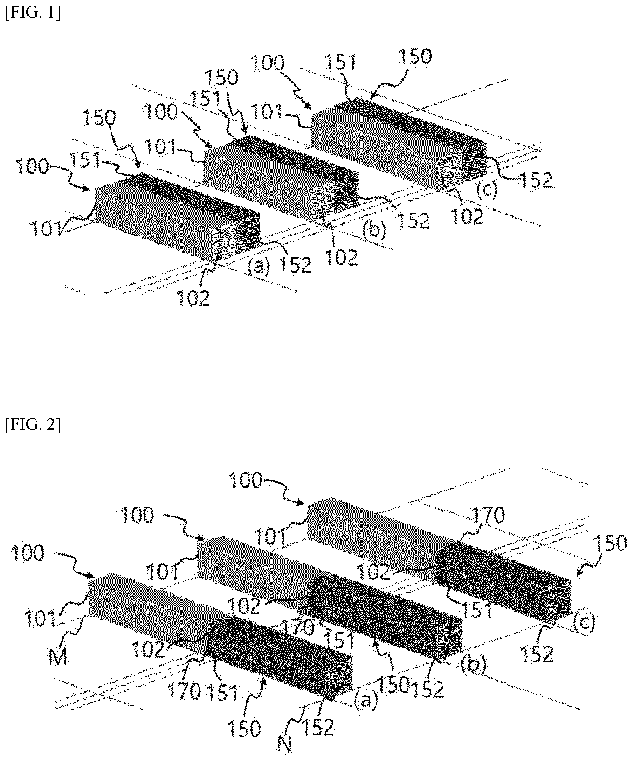

A power factor improvement and power generation apparatus using a piezoelectric element according to an embodiment of the present invention is described hereafter with reference to FIG. 1.

FIG. 1 is a view illustrating a power factor improvement and power generation apparatus using a piezoelectric element according to an embodiment of the present invention.

Referring to FIG. 1, a power factor improvement and power generation apparatus using a piezoelectric element according to an embodiment of the present invention includes, as elements for improving a power factor, a first piezoelectric element 100 having first and second electrodes 101 and 102 and a second piezoelectric element 150 having first and second electrodes 151 and 152 and generating electricity in accordance with vibration of the first piezoelectric element 100.

The first piezoelectric element 100 vibrates by receiving voltage from a power line. In more detail, the first piezoelectric element 100, as shown in (a) of FIG. 1, has the first electrode 101 at an end and the second electrode 102 at another end.

The first piezoelectric element 100 can improve the power factor of a power line using the inherent condenser component, which the first piezoelectric element 100 has, instead of a condenser for improving a power factor.

The second piezoelectric element 150 is disposed to be connected with the first piezoelectric element 100 in parallel. The second piezoelectric element 150 also has the first electrode 151 at an end and the second electrode 152 at another end. Although the second piezoelectric element 150 is disposed to be connected with the first piezoelectric element 100 in parallel in FIG. 1, the second piezoelectric element 150 maybe disposed to be connected with the first piezoelectric element 100 in series as shown in FIG. 2.

The first and second piezoelectric elements 100 and 150, for example, may be bonded and fixed to each other by an adhesive.

When the first and second piezoelectric elements 100 and 150 each having longitudinally disposed electrodes are combined in parallel, the first piezoelectric element 100 longitudinally vibrates when voltage is applied to the first piezoelectric element 100 from a power line, and the second piezoelectric element 150 generates electricity due to influence by the vibration.

In detail, when there is no potential difference between the first and second electrodes 101 and 102 of the first piezoelectric element 100, the first and second piezoelectric elements 100 and 150 maintain the original lengths, as shown in (a) of FIG. 1.

However, when (-) voltage lower than that of the first electrode 101 of the first piezoelectric element 100 is applied to the second electrode 102, a potential difference is generated between the electrodes of the first piezoelectric element 100, so the length of the first piezoelectric element 100 decreases, as shown in (b) of FIG. 1. The length of the second piezoelectric element 150 combined with the first piezoelectric element 100 having the decreased length also decreases to be the same as that of the first piezoelectric element 100, so the second electrode 152 of the second piezoelectric element 150 generates (-) voltage lower than that of the first electrode 151.

On the other hand, when (+) voltage higher than that of the first electrode 101 of the first piezoelectric element 100 is applied to the second electrode 102, a potential difference is generated between the electrodes of the first piezoelectric element 100, so the length of the first piezoelectric element 100 increases, as shown in (c) of FIG. 1. The length of the second piezoelectric element 150 combined with the first piezoelectric element 100 having the increased length also increases to be the same as that of the first piezoelectric element 100, so the second electrode 152 of the second piezoelectric element 150 generates (+) voltage higher than that of the first electrode 151.

As described above, when there is a potential difference between the electrodes of the first piezoelectric element 100, the second piezoelectric element 150 combined with the first piezoelectric element 100 vibrates, thereby generating electricity.

The longitudinal vibration of the first piezoelectric element 100 having the shape shown in (a) of FIG. 1 is generated in a way that the piezoelectric body longitudinally superiorly vibrates when an electrical signal is input in the longitudinal direction between the first and second electrodes 101 and 102 from the outside with the piezoelectric element member longitudinally polarized. Accordingly, when the length of the first piezoelectric element 100 is 2.5 or more times the width/height/diameter, vibration that is superior to vibration in the width/height/diameter directions is observed in the longitudinal direction in response to an external electrical signal.

Accordingly, when (-) voltage or (+) voltage is applied to the first piezoelectric element 100 having the first and second electrodes 101 and 102 at both ends, as shown in (b) or (c) of FIG. 1, the length of the first piezoelectric element 100 longitudinally vibrates and the second piezoelectric element 150 combined with the first piezoelectric element 100 in parallel also vibrates in the same longitudinal direction, thereby generating electricity.

It was described in this embodiment that the first piezoelectric element 100 has a structure that longitudinally vibrates, that is, has a longitudinally vibrating structure, and the second piezoelectric element 150 also has a structure that longitudinally vibrates with vibration of the first piezoelectric element 100. However, the present invention is not limited thereto, and as shown in FIGS. 2 to 7, it is possible to achieve an apparatus that can not only improve the power factor of a power line, but generate power through a structure that generates longitudinal vibration, transverse vibration, shearing vibration, or a combination thereof.

Hereafter, a power factor improvement and power generation apparatus using a piezoelectric element according to another embodiment of the present invention is described with reference to FIGS. 2 to 7.

First, the power factor improvement and power generation apparatus using a piezoelectric element shown in FIG. 2 includes, other than the first piezoelectric element 100 and the second piezoelectric element 150 described in the previous embodiment, an insulator 170 positioned between the first piezoelectric element 100 and the second piezoelectric element 150.

The power factor improvement and power generation apparatus using a piezoelectric element according to another embodiment of the present invention, as shown well in FIG. 2, further includes an object (e.g., a supporting member and a membrane member) to which both ends of the first and second piezoelectric elements 100 and 150 are coupled, thereby having a structure in which an end of each of the first and second piezoelectric elements 100 and 150, in more detail, the portion of the first electrode 101 of the first piezoelectric element 100 and the portion of the second electrode 152 of the second piezoelectric element 150 are coupled and fixed to edges of the external object, respectively.

The first and second piezoelectric elements 100 and 150, as described in the previous embodiment, have first and second electrodes 101 and 102, and 151 and 152, respectively. Unlike the previous embodiment, in this embodiment, the first piezoelectric element 100 and the second piezoelectric element 150 are disposed to be connected in series, and the insulator 170 is disposed between the second electrode 102 of the first piezoelectric element 100 and the first electrode 151 of the second piezoelectric element 150.

The first and second piezoelectric elements 100 and 150 coupled to the edges M and N of the external object maintain the same lengths, as shown in (a) of FIG. 2, when there is no potential difference between the electrodes of the first piezoelectric element 100.

However, when (-) voltage lower than that at the first electrode 101 of the first piezoelectric element 100 is applied to the second electrode 102, a potential difference is generated between the electrodes of the first piezoelectric element 100, so the length of the first piezoelectric element 100 decreases, as shown in (b) of FIG. 2. The length of the second piezoelectric element 150 longitudinally combined with the first piezoelectric element 100 having the decreased length increases, so the second electrode 152 of the second piezoelectric element 150 generates (+) voltage higher than that of the first electrode 151.

On the other hand, when (+) voltage higher than that of the first electrode 101 of the first piezoelectric element 100 is applied to the second electrode 102, a potential difference is generated between the electrodes of the first piezoelectric element 100, so the length of the first piezoelectric element 100 increases, as shown in (c) of FIG. 2. The length of the second piezoelectric element 150 longitudinally combined with the first piezoelectric element 100 having the increased length decreases, so the second electrode 152 of the second piezoelectric element 150 generates (-) voltage lower than that of the first electrode 151.

As described above, when there is a potential difference between the electrodes of the first piezoelectric element 100, the second piezoelectric element 150 combined with the first piezoelectric element 100 in series vibrates, thereby generating electricity.

Accordingly, when (-) voltage or (+) voltage is applied to the first piezoelectric element 100, as shown in (b) or (c) of FIG. 2, the length of the first piezoelectric element 100 longitudinally vibrates and the second piezoelectric element 150 combined with the first piezoelectric element 100 in series also vibrates in the same longitudinal direction, thereby generating electricity.

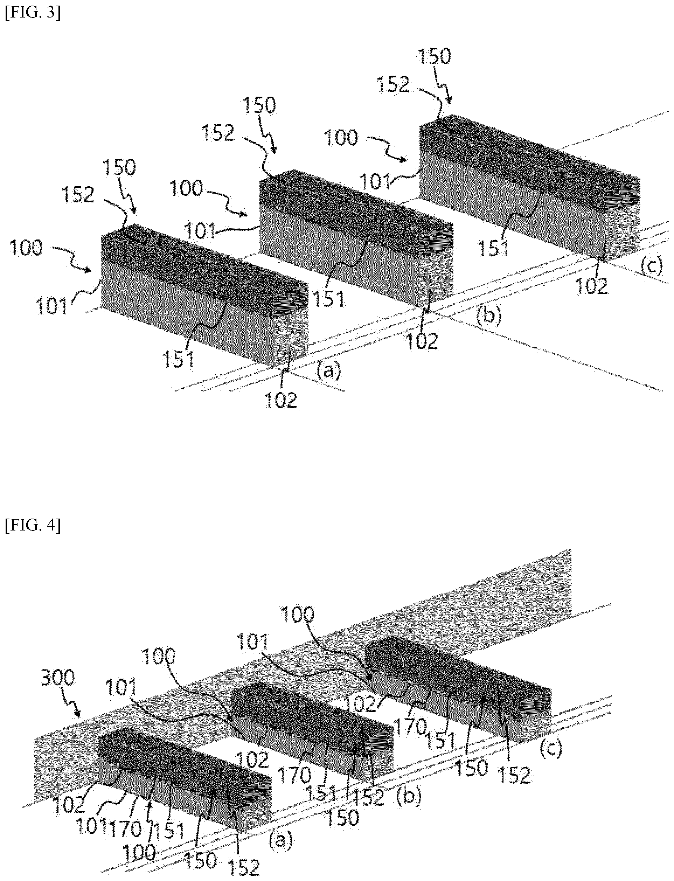

FIG. 3 shows a first piezoelectric element 100 that longitudinally vibrates, that is, has a longitudinally vibrating structure, and a second piezoelectric element 150 that vibrates in the width direction, that is, having a transversely vibrating structure on the first piezoelectric element 100.

Unlike the structure shown in FIG. 3, a second piezoelectric element 150 having a longitudinally vibrating structure may be disposed on a first piezoelectric element 100 having a transversely vibrating structure, and in this structure, it is the same that the second piezoelectric element 150 generates electricity due to influence of vibration.

The first piezoelectric element 100 and the second piezoelectric element 150 are bonded and fixed to each other, for example, by an adhesive, and when (-) voltage lower than that of the first electrode 101 of the first piezoelectric element 100 is applied to the second electrode 102, a potential difference is generated between the electrodes of the first piezoelectric element 100, so the length of the first piezoelectric element 100 decreases, as shown in (b) of FIG. 3. The length of the second piezoelectric element 150 combined with the first piezoelectric element 100 having the decreased length also decreases to be the same as that of the first piezoelectric element 100, so the second electrode 152 of the second piezoelectric element 150 generates (-) voltage lower than that of the first electrode 151.

On the other hand, when (+) voltage higher than that of the first electrode 101 of the first piezoelectric element 100 is applied to the second electrode 102, a potential difference is generated between the electrodes of the first piezoelectric element 100, so the length of the first piezoelectric element 100 increases, as shown in (c) of FIG. 3. The length of the second piezoelectric element 150 combined with the first piezoelectric element 100 having the increased length also increases to be the same as that of the first piezoelectric element 100, so the second electrode 152 of the second piezoelectric element 150 generates (+) voltage higher than that of the first electrode 151.

In this case, transverse vibration is generated in the way that when an electrical signal is input from the outside in the thickness direction with a piezoelectric body is polarized in the thickness direction, the piezoelectric body vibrates only in the transverse direction (width direction). In order for superior vibration to be observed only in the transverse direction in response to an external electrical signal in a real situation, when the width-directional size of a piezoelectric body is 10 or more times the length or thickness, vibration that is superior to vibration in the length/height directions is observed in the width direction in response to an external electrical signal.

Accordingly, when (-) voltage or (+) voltage is applied to the first piezoelectric element 100 having a longitudinally vibrating structure, the length of the first piezoelectric element 100 longitudinally vibrates, and, as shown in (b) or (c) of FIG. 3, the second piezoelectric element 150 stacked on the first piezoelectric element 100 vibrates in the width direction, thereby generating electricity.

It is also possible to achieve a structure in which when (-) voltage or (+) voltage is applied to the first piezoelectric element having the stacked structure and the structure generating width-directional vibration, as shown in FIG. 3, the first piezoelectric element 100 vibrates in the width direction and the second piezoelectric element disposed under the first piezoelectric element and having a longitudinally vibrating structure longitudinally vibrates, thereby generating electricity.

FIG. 4 shows a first piezoelectric element 100 that transversely vibrates, that is, shows longitudinal vibration, and a second piezoelectric element 150 that transversely vibrates on the first piezoelectric element 100. In the structure in which the first and second piezoelectric elements 100 and 150 are stacked in this way, an insulator 170 is positioned between the first and second piezoelectric elements 100 and 150.

Further, as shown in FIG. 4, a supporting member 300 that supports the first and second piezoelectric elements 100 and 150 may be installed. Although the supporting member 300 is disposed close to the first electrodes 101 and 151 of the first and second piezoelectric elements 100 and 150, but it is not necessarily disposed at that position.

When (-) voltage or (+) voltage is applied to the first piezoelectric element 100 having a transversely vibrating structure, as shown in (b) or (c) of FIG. 4, the first piezoelectric element 100 vibrates in the width direction and the second piezoelectric element 150 stacked on the first piezoelectric element 100 also vibrates in the width direction, thereby generating electricity.

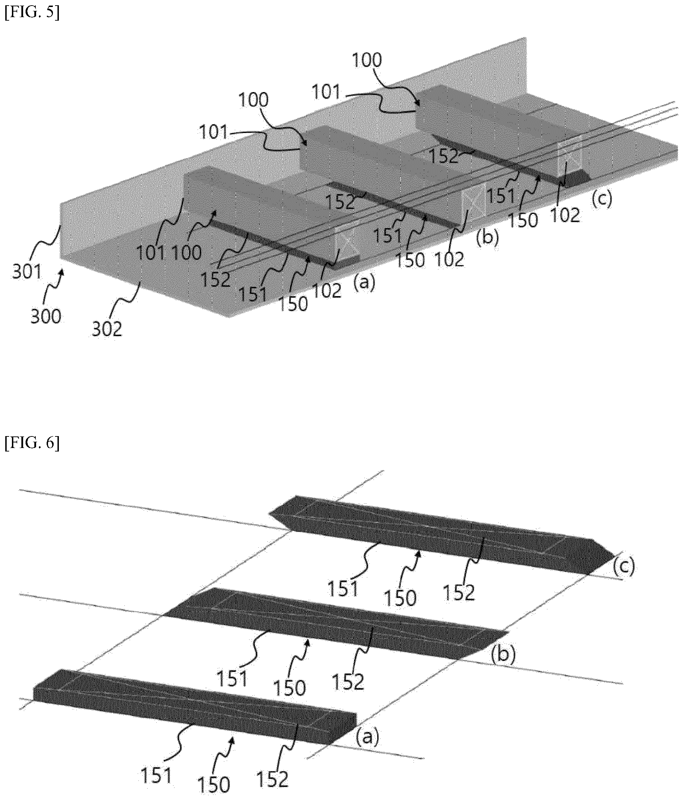

FIG. 5 shows a first piezoelectric element 100 that longitudinally vibrates and a second piezoelectric element 150 that is disposed under the first piezoelectric element 100 and vibrates in the shearing direction.

As shown well in FIG. 5, an electrode surface of the second piezoelectric element 150 is coupled to a surface that is not an electrode surface of the first piezoelectric element 100, and one surface of the first piezoelectric element 100, in detail, the surface on which the first electrode 101 is positioned, and the bottom of the second piezoelectric element 150, in detail, the surface on which the first electrode 151 is positioned, are supported by a supporting member 300. The supporting member 300 may have an L-shape, but the shape does not limit the present invention.

A vertical surface 301 of the supporting member 300 supports the first electrode surface 101 of the first piezoelectric element 100, a horizontal surface 302 of the supporting member 300 supports the first electrode surface 151 of the second piezoelectric element 150, and the second piezoelectric element 150 disposed under the first piezoelectric element 100 and the vertical surface 301 are spaced apart from each other. Unlike the previous embodiments, the length of the first piezoelectric element 100 is larger than the length of the second piezoelectric element 150.

When (+) voltage higher than that of the first electrode 101 of the first piezoelectric element 100 having this structure is applied to the second electrode 102, a potential difference is generated between the electrodes of the first piezoelectric element 100, so the length of the first piezoelectric element 100 increases, as shown in (b) of FIG. 5. The second piezoelectric element 150, which is combined with the first piezoelectric element 100 having the decreased length and vibrates in the shearing direction, is deformed, so the second electrode 152 of the second piezoelectric element 150 generates (+) voltage higher than that of the first electrode 151. When (+) voltage is applied to the second electrode 102 of the first piezoelectric element 100, as described above, the second piezoelectric element 150 is deformed such that the top inclines to the right, which is shown well in (b) of FIG. 6.

On the other hand, when (-) voltage lower than that of the first electrode 101 of the first piezoelectric element 100 is applied to the second electrode 102, a potential difference is generated between the electrodes of the first piezoelectric element 100, so the length of the first piezoelectric element 100 decreases, as shown in (c) of FIG. 5. The second piezoelectric element 150 combined with the first piezoelectric element 100 having the decreased length is deformed in the opposite direction to that in (b) of FIG. 5, so the second electrode 152 of the second piezoelectric element 150 generates (-) voltage lower than that of the first electrode 151. When (-) voltage is applied to the second electrode 102 of the first piezoelectric element 100, as described above, the second piezoelectric element 150 is deformed such that the top inclines to the left, which is shown well in (c) of FIG. 6.

Accordingly, when (-) voltage or (+) voltage is applied to the first piezoelectric element 100 having a longitudinally vibrating structure, the length of the first piezoelectric element 100 longitudinally vibrates, and the second piezoelectric element 150 disposed under the first piezoelectric element 100 and vibrating in the shearing direction vibrates in the shearing direction, thereby generating electricity.

Similarly, it is also possible to achieve a structure in which when (-) voltage or (+) voltage is applied to the first piezoelectric element having the stacked structure and the structure generating shearing vibration, as shown in FIG. 6, the first piezoelectric element 100 vibrates in the shearing direction and the second piezoelectric element disposed on the first piezoelectric element and longitudinally vibrating longitudinally vibrates, thereby generating electricity.

The vibration in the shearing direction (thickness slide vibration) is generated in the way that when an electrical signal is input in the thickness direction from the outside with a piezoelectric body is longitudinally polarized, the top and the bottom in the thickness direction of the piezoelectric body vibrate in opposite directions.

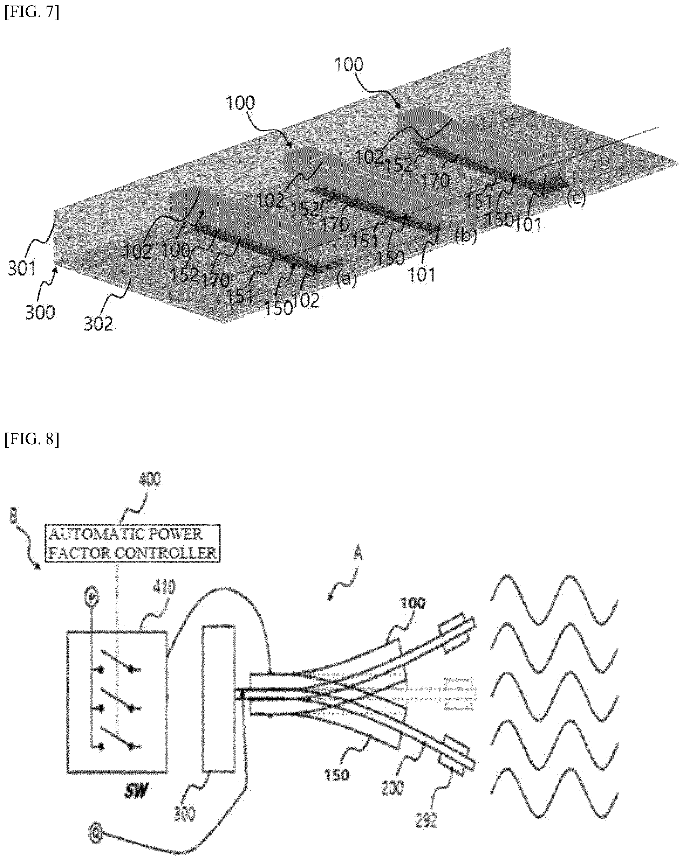

FIG. 7 shows a first piezoelectric element 100 that transversely vibrates and a second piezoelectric element 150 that is disposed under the first piezoelectric element 100 and vibrates in the shearing direction.

As shown in FIG. 7, an insulator 170 is disposed between the electrode surface of the first piezoelectric element 100 and the electrode surface of the second piezoelectric element 150. The surface on which the first and second electrodes 101 and 102 of the first piezoelectric element 100 are not positioned and the surface on which the first electrode 151 of the second piezoelectric element 150 is positioned are supported by the supporting member 300 shown in FIG. 6.

The vertical surface 301 of the supporting member 300 supports the first piezoelectric element 100, the horizontal surface 302 of the supporting member 300 supports the second piezoelectric element 150, and the second piezoelectric element 150 disposed under the first piezoelectric element 100 and the vertical surface 301 are spaced apart from each other. In this case, the length of the first piezoelectric element 100 is larger than the length of the second piezoelectric element 150.

When (+) voltage higher than that of the first electrode 101 of the first piezoelectric element 100 having this structure is applied to the second electrode 102, a potential difference is generated between the electrodes of the first piezoelectric element 100, so the length of the first piezoelectric element 100 increases, as shown in (b) of FIG. 7. The second piezoelectric element 150, which is combined with the first piezoelectric element 100 having the decreased length and vibrates in the shearing direction, is deformed, so the second electrode 152 of the second piezoelectric element 150 generates (+) voltage higher than that of the first electrode 151.

On the other hand, when (-) voltage lower than that of the first electrode 101 of the first piezoelectric element 100 is applied to the second electrode 102, a potential difference is generated between the electrodes of the first piezoelectric element 100, so the length of the first piezoelectric element 100 decreases, as shown in (c) of FIG. 7. The second piezoelectric element 150 combined with the first piezoelectric element 100 having the decreased length is deformed in the opposite direction to that in (b) of FIG. 7, so the second electrode 152 of the second piezoelectric element 150 generates (-) voltage lower than that of the first electrode 151.

Accordingly, when (-) voltage or (+) voltage is applied to the first piezoelectric element 100 having a transversely vibrating structure, the first piezoelectric element 100 longitudinally vibrates, and the second piezoelectric element 150 disposed under the first piezoelectric element 100 and vibrating in the shearing direction vibrates in the shearing direction, thereby generating electricity.

Similarly, it is also possible to achieve a structure in which when (-) voltage or (+) voltage is applied to the first piezoelectric element having the stacked structure and the structure generating shearing vibration, as shown in FIG. 7, the first piezoelectric element 100 vibrates in the shearing direction and the second piezoelectric element disposed on the first piezoelectric element and transversely vibrating transversely vibrates, thereby generating electricity.

FIG. 8 shows a power factor improvement and power generation apparatus using a piezoelectric element according to another embodiment of the present invention.

As shown in FIG. 8, a power factor improvement and power generation apparatus using a piezoelectric element according to another embodiment of the present invention includes a first piezoelectric element 100, a second piezoelectric element 150, a membrane member 200 positioned between the first piezoelectric element 100 and the second piezoelectric element 150, an actuator A including a supporting member 300 supporting the membrane member 200, and an automatic power factor control unit B supplying power to the first piezoelectric element.

The first and second piezoelectric elements 100 and 150 may have a transversely vibrating structure.

The first piezoelectric element 100 is supplied with power from a power line. In more detail, the first piezoelectric element is controlled by the automatic power factor control unit B to receive voltage of a power terminal and transversely vibrate.

As the first piezoelectric element 100 vibrates, the membrane member 200 fixed to the supporting member 300 generates a bending motion that generates mechanical displacement. The second piezoelectric element 150 generates electricity due to the bending motion of the membrane member 200. The mechanical displacement generated by the bending motion of the membrane member 200 may be used as a cooling fan. A weight 292 is installed at an end of the membrane member 200, so the amplitude of the bending motion is increased, whereby the power generation amount can be increased.

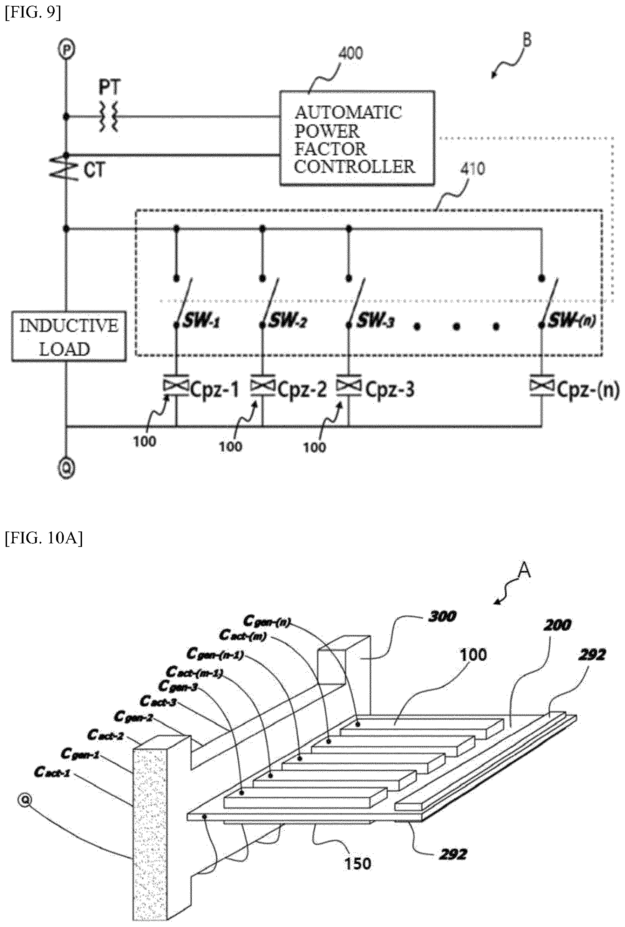

FIG. 9 shows the automatic power factor control unit connected to a power line for supplying power to the first piezoelectric element 100 of FIG. 8.

The automatic power factor control unit B is described with reference to FIG. 9. The automatic power factor control unit B includes: an automatic power factor controller 400 that includes first piezoelectric elements 100 (Cpz-1, Cpz-2, Cpz-3..., Cpz-(n)), an ammeter CT installed on a power line P, Q at a side of a power terminal and providing an output signal that is proportioned to the current flowing through the power line P, Q, and a voltmeter PT converting voltage of the power terminal into proportional low voltage and measuring the voltage, and that automatically controls a power factor on the basis of current and voltage measured by the ammeter and the voltmeter; and a switching unit 410 that is electrically connected to the automatic power factor controller 400 and switches selective connection with the first piezoelectric elements 100 (Cpz-1, Cpz-2, Cpz-3..., Cpz-(n)) that are connected in parallel in accordance with control by the automatic power factor controller 400.

The automatic power control unit B, as shown in the one-line diagram of FIG. 9, measures the actual power factor of a power line and selectively supplies power to several first piezoelectric elements 100 connected in parallel by the capacity of a condenser required for power factor improvement by controlling several first piezoelectric elements 100. Accordingly, the power factor of power can be increased.

Referring to FIG. 8, the first piezoelectric element 100 can improve a power factor using the electrical characteristic as a condenser and the membrane member 200 positioned between the first and second piezoelectric elements 100 and 200 and generates mechanical displacement by converse piezoelectric effect generated from an electrical characteristic. The converse piezoelectric effect is a phenomenon in which when voltage is applied to the first piezoelectric element 100 from the outside, the membrane member 200 to which the first piezoelectric element 100 is attached generates mechanical displacement (here, which means a bending motion or a wave motion). The second piezoelectric element 150 attached to the membrane member 200 generates electricity due to such a bending motion or wave motion.

Since the more the first piezoelectric elements 100 are connected in parallel, the larger the condenser capacity, the automatic power factor control unit B can perform control such that power is supplied only to the first piezoelectric elements 100 electrically connected to the power line P, Q by adjusting the switching unit 410 to be described above by the amount of required power factor improvement. Accordingly, when it is an inductive load, reactive power is supplied to the first piezoelectric elements 100 switched and electrically connected by the switching unit 410, whereby the power factor of power can be improved.

The switching unit 410 is composed of switches $SW_{-1}$, $SW_{-2}$, $SW_{-3}$..., and $SW_{-(n)}$ that are connected to the output terminal of the automatic power factor controller 400, are provided to correspond to the first piezoelectric elements 100 )(Cpz-1, Cpz-2, Cpz-3..., Cpz-(n)) connected in parallel, respectively, and can switch states to open/close the electric paths to the first piezoelectric elements 100 (Cpz-1, Cpz-2, Cpz-3..., Cpz-(n)). The states are switched such that a corresponding switch (at least one switch of $SW_{-1}$, $SW_{-2}$, $SW_{-3}$..., and $SW_{-(n)}$ is switched and opens/closes the electric path to a corresponding first piezoelectric element 100 (Cpz-1, Cpz-2, Cpz-3..., Cpz-(n)) in response to a control signal of the automatic power factor controller 400.

The switching unit 410 may include a relay unit composed of relays or electronic switches, which open/close electric paths to simultaneously open or put in the electric paths to corresponding first piezoelectric elements 100 (Cpz-1, Cpz-2, Cpz-3..., Cpz-(n)) in accordance with the switching state of corresponding switches, and nodes thereof.

The automatic power factor controller 400 connected to the switching unit 410 finds out a condenser that satisfies a target power factor by comparing reactive power, which is calculated using output signals from the voltmeter PT and the ammeter CT, with a predetermined condenser capacity, and outputs a control signal for simultaneously opening/closing the electric paths to corresponding condensers.

Since it is possible to simultaneously control several first piezoelectric elements 100 (Cpz-1, Cpz-2, Cpz-3..., Cpz-(n)) by comparing reactive power and a condenser capacity, it is possible to maintain the power factor within a target range. Further, the power factor of power can be further improved by the electrical characteristics that several first piezoelectric elements 100 (Cpz-1, Cpz-2, Cpz-3..., Cpz-(n)) have as condensers.

Hereafter, an actuator A connected to the automatic power factor control unit B is described in detail.

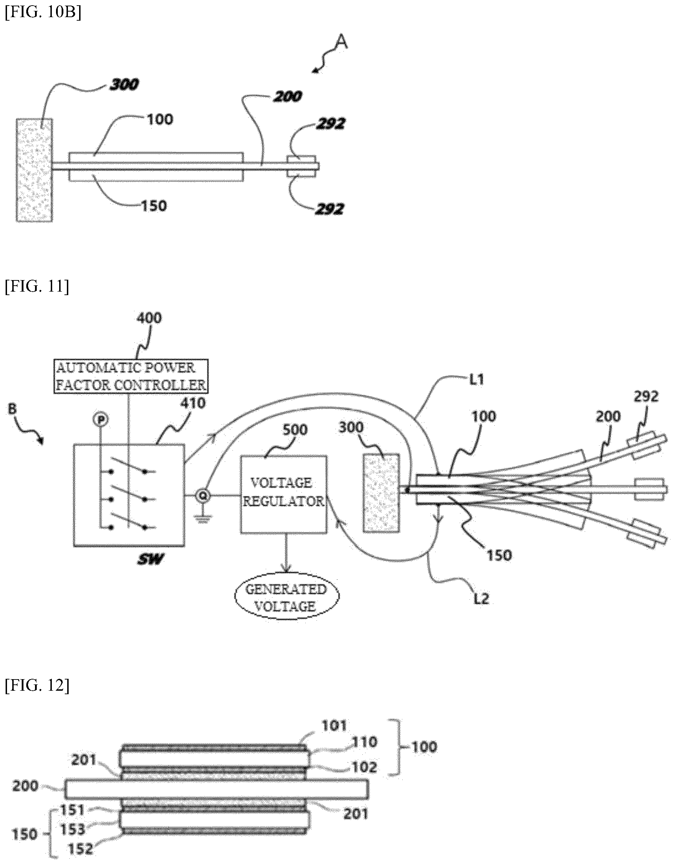

FIGS. 10A and 10B are views showing the actuator shown in FIG. 8. In more detail, FIG. 10A is a perspective view illustrating the actuator shown in FIG. 8 and FIG. 10B is a cross-sectional view illustrating the actuator shown in FIG. 10A.

Referring to FIG. 10A, an actuator A includes a membrane member 200, and first and second piezoelectric elements 100 and 150 attached to the top and the bottom of the membrane member 200, respectively.

As shown in FIG. 10A, pluralities of first and second piezoelectric elements 100 and 150 may be attached to the top and the bottom of the membrane member 200. Since the second piezoelectric elements 150 are attached to the top and the bottom of the membrane member 200, it is possible to provide an environment in which electricity can always be generated by a bending motion of the membrane member 200.

However, if necessary, the second piezoelectric elements 150 may be attached only to the top or the bottom of the membrane member 200.

Although the corresponding numbers of first and second piezoelectric elements 100 and 150 are attached to the top and the bottom of the membrane member 200, respectively, in this embodiment, the present invention is not necessarily limited thereto, and the numbers of the first and second piezoelectric elements 100 and 150 attached to the top and the bottom of the membrane member 200 may be different from each other.

It is preferable to determine the numbers of the first and second piezoelectric elements 100 and 150 attached to the membrane member 200 in consideration of the internal environment (e.g., the size of the internal space) of an enclosure.

The actuator A includes a weight 292 disposed at an end of the membrane member 200 far from the supporting member 300 to increase the weight of the end of the membrane member 200, as shown in FIGS. 10A and 10B, thereby being able to further increase the amplitude of the bending motion. When the amplitude is increased in this way, the power generation amount is also increased.

Although the weight 292 is installed on both the top and the bottom of the membrane member 200 in FIGS. 10A and 10B, the present invention is not necessarily limited thereto and the weight 292 may be installed only on the top or the bottom of the membrane member 200. Since the weight 292 for increasing the weight at the end of the membrane member 200 is included, the amplitude of the bending motion can be further increased.

The voltage generated by the second piezoelectric element 150 is transmitted to a voltage regulator 500 (see FIG. 11). The voltage regulator 500, depending on the purpose of use, may supply the AC voltage generated by the second piezoelectric element 150 to the outside or may convert the AC voltage into DC voltage through a rectifier (not shown) and then supply the DC voltage to the outside. Accordingly, it is possible to supply voltage required by a user.

FIG. 12 is a cross-sectional view of a bimorph type actuator element in which a second piezoelectric element 150, which is the same as a first piezoelectric element 100 attached to a side of the membrane member 200, is attached to another side of the membrane member 200.

When the first piezoelectric element 100 and the membrane member 200 have the same current expansion ratio, even though the first piezoelectric element 100 expands, the membrane member 200 also expands with the same ratio, so the first piezoelectric element 100 and the membrane member 200 do not bend. However, the first piezoelectric element 100 expands or contracts, but the membrane member 200 expands or contracts with a very low ratio, so the end of the membrane member 200 bonded to the first piezoelectric element 100 bends up and down. This is similar to the principle of bimetal.

The membrane member 200 and the first piezoelectric element 100 are bonded by an adhesive 201, and the adhesive 201 is an adhesive that is generally used for a piezoelectric buzzer.

As can be seen from the following proportional expression 1, the smaller the thickness t of the membrane member 200 and the larger the length L of the membrane member 200, the smaller the resonant frequency $f_{res}$. In the following proportional expression 1, $f_{res}$ is a resonant frequency, k is a proportional constant, t is the thickness of the membrane member 200, L is the length from the supporting member 300 to an end of the membrane member 200, E is Young's modulus, $\rho$ is density of the membrane member 200, and $\upsilon$ is Poisson's ratio.

$$f_{res} = \frac{k \cdot t}{L^2} \sqrt{\frac{E}{\rho(1-\upsilon^2)}} \quad \text{------------------}(1)$$

When an electrical signal is input to the first piezoelectric element 100, the first piezoelectric element 100 contracts or expands, and the first piezoelectric element 100 and the membrane member 200 are bent up and down by the contract or expansion motion of the first piezoelectric element 100.

Mechanical displacement generated by the bending motion functions as a cooling fan that discharges hot air, which comes from the inside of the enclosure, to the outside. Accordingly, there is no need for a separate cooling fan and it is also possible to usefully use reactive power even without using specific power. In particular, the surrounding temperature in the enclosure can be adjusted, for example, to the regulated temperature by International Standards IEX 60831-2 and Korea Standards KSC 4801 that is the same as International Standards.

[Table 1]

| Symbol | Surrounding temperature (°C) | | |
|---|---|---|---|
| | Maximum temperature | Average for 24 hours | |
| A | 40 | 30 | 20 |
| B | 45 | 35 | 25 |
| c | 50 | 40 | 30 |
| D | 55 | 45 | 35 |

This can be seen from the following proportional expression (2). In the following proportional expression (2), $\delta_{max}$ is the maximum amplitude at the end of the membrane member 200, P is flexural strength of the first piezoelectric element 100, E is Young's modulus, w is the width of the membrane member 200, L is the length of the membrane member 200, and t is the thickness of the membrane member 200.

$$\delta_{max} \propto \frac{P \cdot L^3}{E \cdot w \cdot t^3} \quad \text{-----------------}(2)$$

In an embodiment of the present invention, as shown in FIG. 12, the second piezoelectric element 150 can be bonded to not only the top of the membrane member 200, but the bottom. The case in which the first piezoelectric element 100 and the second piezoelectric element 150 are attached to both the top and bottom of the membrane member 200 in this way is called a bimorph type.

It is efficient to use a conductive material such as a brass plate, a nickel alloy plate, white bronze, phosphor bronze, and stainless steel for the membrane member 200.

The first piezoelectric element 100 includes a piezoelectric body 110 and first and second electrodes 101 and 102 for receiving an electrical signal that is applied from an external driving circuit, and the second piezoelectric element 150 includes a piezoelectric body 153 and first and second electrodes 151 and 152 for receiving an electrical signal that is applied from an external driving circuit. The electrodes 101, 102, 151, and 152 of the first and second piezoelectric elements 100 and 150 may be made of gold (Au), silver (Ag), white gold (Pt), aluminum (Al), copper (Cu), lead (Pb), or an alloy thereof.

The electrodes 101, 102, 151, and 152 generate mechanical vibration when an electrical signal is applied from the outside. The membrane member 200 is not necessarily made of a conductive material, but if the membrane member 200 is conductive, the membrane member 200 can be used as an electrode.

The piezoelectric bodies 110 and 153 in another embodiment of the present invention are made of a common piezoelectric material such as PZT and PVDF.

The membrane member 200 may be made of all materials that have high elasticity and electrical conductivity and can be vibrated by a bending motion of the first piezoelectric element 100, but when the membrane member 200 is used as an electrode, the membrane member 200 is made of one or more of a copper alloy plate, a nickel alloy plate, a stainless steel plate, and a titanium plate.

An elastic member 360 such as rubber, foamed polyurethane, elastomer, and silicone may be attached between the supporting members 300.

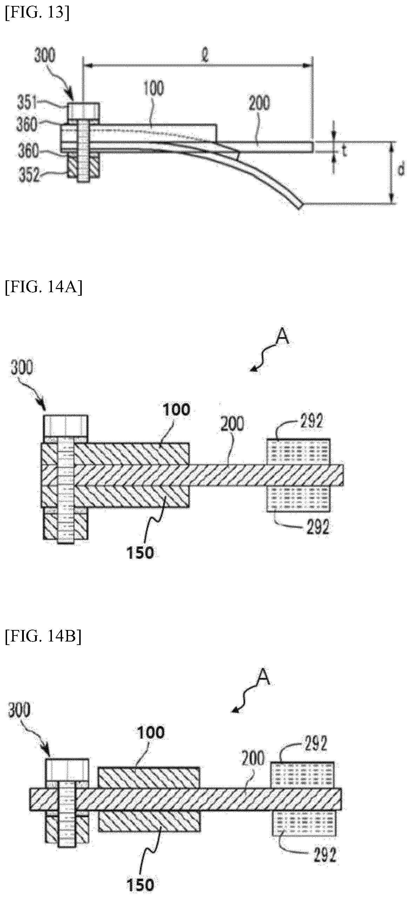

FIG. 13 shows the shape in which the first piezoelectric element 100 and the membrane member 200 are coupled to bolt and nut 351 and 352 that are supporting members 300 according to an embodiment of the present invention, in which the proportional expression (1) and the proportional expression (2) are applied as they are. That is, the resonant frequency is related to the length and thickness of the membrane member 200.

Accordingly, it is preferable to design the length of the membrane member 200 such that a line frequency (e.g., 60Hz in Korean) is the resonant frequency.

Hereafter, vibration of the membrane member 200 according to the present invention is described.

When (+) voltage and (-) voltage are applied to electrodes applied to the top and bottom of the piezoelectric body 110, respectively, the piezoelectric body 110 contracts or expands.

If the first piezoelectric element 100 expands, the membrane member 200 bonded to the first piezoelectric element 100 hardly expands, but the current expansion ratio of the piezoelectric body 110 is much larger than the current expansion ratio of the membrane member 200, so expansion of the membrane member 200 is almost ignored. Accordingly, the membrane member 200 generates a bending motion in which both ends bend down, similar to bimetal.

When the electrical signals applied to the electrodes are switched, an opposite phenomenon occurs. Accordingly, when AC electricity is applied to the electrodes, the first piezoelectric element 100 and the membrane member 200 repeatedly and alternately bend up and down. Accordingly, when an end of the membrane member 200 bends like a cantilever, as shown in FIG. 13, the amplitude due to the bending motion at the opposite end is much increased.

In another embodiment of the present invention, as shown in FIG. 14A, the first piezoelectric element 100 and the second piezoelectric element 150 may be in close contact with the support member 300 and the membrane member 200 between the first piezoelectric element 100 and the second piezoelectric element 150 may be supported by the supporting member 300. Further, as shown in FIG. 14B, the first piezoelectric element 100 and the second piezoelectric element 150 may be disposed with a predetermined gap from the supporting member 300 and the membrane member 200 between the first piezoelectric element 100 and the second piezoelectric element 150 may be supported by the supporting member 300.

Bolt 351 and nut 352 are an example of the supporting member 300.

The weight 292 attached to an end of the membrane member 200 may be further included. The weight 292 is provided to increase weight and can further increase the amplitude of a bending motion.

Accordingly, the amplitude of the membrane member 200 is increased, whereby the function as a cooling fan can be increased.

The above description merely explains the spirit of the present invention and the embodiment may be changed and modified in various ways without departing from the spirit of the embodiment by those skilled in the art. Accordingly, the embodiments described herein are provided merely not to limit, but to explain the spirit of the present invention, and the spirit of the present invention is not limited by the embodiments. The protective range of the present invention should be construed by the following claims and the scope and spirit of the present invention should be construed as being included in the patent right of the present invention.

**Claims**

1. An apparatus comprising:

   a first piezoelectric element having first and second electrodes, and vibrating when voltage is applied from a power line; and
   a second piezoelectric element having first and second electrodes, and generating electricity in accordance with vibration of the first piezoelectric element.

2. The apparatus of claim 1, further comprising an insulator disposed between the first piezoelectric element and the second piezoelectric element.

3. The apparatus of claim 1, wherein the first piezoelectric element has a structure that generates transverse vibration, longitudinal vibration, or shearing vibration, and the second piezoelectric element has a structure that generates transverse vibration, longitudinal vibration, or shearing vibration in accordance with vibration of the first piezoelectric element.

4. The apparatus of claim 3, further comprising:

   a membrane member positioned between the first piezoelectric element and the second piezoelectric element; and
   a supporting member supporting the membrane member,
   wherein the membrane member generates mechanical displacement through a bending motion generated in a fixed state to the supporting member, and the second piezoelectric element vibrates and generates electricity by the bending motion.

5. The apparatus of claim 1, wherein pluralities of the first and second piezoelectric elements are provided, the first piezoelectric element and the second piezoelectric element are disposed on the top, the bottom, or a combination thereof of the membrane member, and at least one second piezoelectric element is disposed on each of the top and the bottom of the membrane member.

6. The apparatus of claim 2, wherein the first piezoelectric element is used as a material of a condenser for compensating a power factor of the power line, the plurality of the first piezoelectric element is provided and they are connected to the power line in parallel, and the apparatus further includes an automatic power factor control unit selectively controlling the first piezoelectric elements connected in parallel by the amount required by a load.

7. The apparatus of claim 6, wherein the automatic power factor control unit includes: an automatic power factor controller that automatically controls a power factor on the basis of current and voltage measured by an ammeter and a voltmeter; and a switching unit that is electrically connected to the automatic power factor controller to switch connection with the first piezoelectric elements in accordance with control of the automatic power factor controller.

8. The apparatus of claim 4, further comprising a weight attached to an end of the membrane member.

[FIG. 1]

[FIG. 2]

EP 4 084 255 A1

[FIG. 3]

[FIG. 4]

[FIG. 5]

[FIG. 6]

[FIG. 7]

[FIG. 8]

[FIG. 9]

[FIG. 10A]

[FIG. 10B]

[FIG. 11]

[FIG. 12]

[FIG. 13]

[FIG. 14A]

[FIG. 14B]

## INTERNATIONAL SEARCH REPORT

| International application No. |
| --- |
| **PCT/KR2020/018402** |

**A.     CLASSIFICATION OF SUBJECT MATTER**

**H02J 3/18**(2006.01)i; **H02N 2/18**(2006.01)i; **H01L 41/113**(2006.01)i; **H01L 27/20**(2006.01)i

According to International Patent Classification (IPC) or to both national classification and IPC

**B.     FIELDS SEARCHED**

Minimum documentation searched (classification system followed by classification symbols)

H02J 3/18(2006.01); B62D 24/00(2006.01); F16F 15/08(2006.01); G01R 21/00(2006.01); G10K 9/122(2006.01); H01L 41/04(2006.01); H02B 1/24(2006.01); H02N 2/00(2006.01); H04R 17/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 압전(piezo-electric), 진동(vibration), 전극(electrode), 멤브레인(membrane)

**C.     DOCUMENTS CONSIDERED TO BE RELEVANT**

| Category* | Citation of document, with indication, where appropriate, of the relevant passages | Relevant to claim No. |
| --- | --- | --- |
| X<br><br>Y | JP 6409357 B2 (ISUZU MOTORS LTD.) 24 October 2018 (2018-10-24)<br>    See paragraphs [0031]-[0035] and figure 1. | 1-3<br><br>4-8 |
| Y | KR 10-2012-0072310 A (AR SPACER CO., LTD.) 03 July 2012 (2012-07-03)<br>    See paragraphs [0032]-[0063] and figures 4-8. | 4-8 |
| Y | JP 2008-125005 A (KENWOOD CORP.) 29 May 2008 (2008-05-29)<br>    See paragraph [0021] and figures 3-4. | 5 |
| Y | KR 10-1664328 B1 (KOREA ELECTRIC RESEARCH ENGINEERING CONSTRUCTION CO., LTD.)<br>11 October 2016 (2016-10-11)<br>    See paragraphs [0022]-[0047] and figures 1-4. | 6-7 |
| Y | JP 2005-312269 A (NEC CORP.) 04 November 2005 (2005-11-04)<br>    See paragraph [0035] and figure 1. | 8 |

| ✓ | Further documents are listed in the continuation of Box C. | ✓ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **26 March 2021** | **26 March 2021** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

| International application No. |
|---|
| **PCT/KR2020/018402** |

| C. | DOCUMENTS CONSIDERED TO BE RELEVANT | |
|---|---|---|
| Category* | Citation of document, with indication, where appropriate, of the relevant passages | Relevant to claim No. |
| PX | KR 10-2158087 B1 (BAIK, Seung Hyun) 23 October 2020 (2020-10-23)<br>See entire document.<br>(This document is a published earlier application that serves as a basis for claiming priority of the present international application.) | 1-8 |

Form PCT/ISA/210 (second sheet) (July 2019)

**INTERNATIONAL SEARCH REPORT**
Information on patent family members

International application No.

**PCT/KR2020/018402**

| Patent document cited in search report | | | Publication date (day/month/year) | Patent family member(s) | | | Publication date (day/month/year) |
|---|---|---|---|---|---|---|---|
| JP | 6409357 | B2 | 24 October 2018 | JP | 2016-006341 | A | 14 January 2016 |
| KR | 10-2012-0072310 | A | 03 July 2012 | CN | 103283261 | A | 04 September 2013 |
| | | | | CN | 103283261 | B | 07 December 2016 |
| | | | | EP | 2658285 | A1 | 30 October 2013 |
| | | | | EP | 2658285 | B1 | 24 October 2018 |
| | | | | JP | 2014-506413 | A | 13 March 2014 |
| | | | | JP | 5647358 | B2 | 24 December 2014 |
| | | | | KR | 10-1180320 | B1 | 06 September 2012 |
| | | | | US | 2013-0287233 | A1 | 31 October 2013 |
| | | | | US | 9226077 | B2 | 29 December 2015 |
| | | | | WO | 2012-087074 | A1 | 28 June 2012 |
| JP | 2008-125005 | A | 29 May 2008 | None | | | |
| KR | 10-1664328 | B1 | 11 October 2016 | None | | | |
| JP | 2005-312269 | A | 04 November 2005 | None | | | |
| KR | 10-2158087 | B1 | 23 October 2020 | None | | | |

Form PCT/ISA/210 (patent family annex) (July 2019)